## Europäisches Patentamt

## European Patent Office

## Office européen des brevets

(11) Veröffentlichungsnummer: **0 104 684**
**B1**

(12) # EUROPÄISCHE PATENTSCHRIFT

(45) Veröffentlichungstag der Patentschrift:
03.05.89

(51) Int. Cl.⁴: **G 03 F 1/00**

(21) Anmeldenummer: 83201241.3

(22) Anmeldetag: 31.08.83

(54) **Maske für die Mustererzeugung in Lackschichten mittels Röntgenstrahllithographie und Verfahren zu ihrer Herstellung.**

(30) Priorität: 01.09.82 DE 3232498

(43) Veröffentlichungstag der Anmeldung:
04.04.84 Patentblatt 84/14

(45) Bekanntmachung des Hinweises auf die Patenterteilung:
03.05.89 Patentblatt 89/18

(84) Benannte Vertragsstaaten:
DE FR GB IT NL

(56) Entgegenhaltungen:
DE-A- 2 520 147
GB-A- 2 089 524

IBM TECHNICAL DISCLOSURE BULLETIN, Band 25, Nr. 6, November 1982, page 2733, New York, US; U. BEHRINGER et al.: "Mask for X-ray lithography with optically transparent registration window"

(73) Patentinhaber: **Philips Patentverwaltung GmbH, Wendenstrasse 35 Postfach 10 51 49, D-2000 Hamburg 1 (DE)**

(84) Benannte Vertragsstaaten: **DE**

(73) Patentinhaber: **N.V. Philips' Gloeilampenfabrieken, Groenewoudseweg 1, NL-5621 BA Eindhoven (NL)**

(84) Benannte Vertragsstaaten: **FR GB IT NL**

(72) Erfinder: **Harms, Margret, Lokstedter Steindamm 48a, D-2000 Hamburg 54 (DE)**
Erfinder: **Lüthje, Holger, Buchenweg 15, D-2083 Halstenbek (DE)**
Erfinder: **Matthiessen, Bernd, Bergstrasse 3, D-2105 Seevetal 6 (DE)**
Erfinder: **Bruns, Angelika, Grosse Lohe 31, D-2359 Henstedt-Ulzburg (DE)**

(74) Vertreter: **Nehmzow-David, Fritzi-Maria et al, Philips Patentverwaltung GmbH Wendenstrasse 35 Postfach 10 51 49, D-2000 Hamburg 1 (DE)**

## Beschreibung

Die Erfindung betrifft eine Maske für die Muster-erzeugung in Lackschichten mittels Röntgen-strahllithographie mit einer für sichtbares Licht undurchlässigen Membran aus Metall und mit einer auf einer der Hauptflächen der Membran befindlichen, die Röntgenstrahlung absorbierenden, entsprechend dem zu erzeugenden Muster strukturierten Schicht.

Die Erfindung betrifft weiterhin ein Verfahren zur Herstellung einer derartigen Maske.

Insbesondere bei der Fertigung von integrierten Halbleiter-Systemen, aber auch z.B. bei der Fertigung von magnetischen Zylinderdomänenanordnungen, besteht eine anhaltende Nachfrage nach immer kleineren Details, und die Auflösung, die heute in der Struktur und in der Maske verlangt wird, nähert sich der Grenze, die durch die Wellenlänge des Lichtes gesetzt wird. Es werden daher bereits andere als lichtoptische Verfahren eingesetzt, um den Übergang zu größerer Auflösung möglich zu machen.

Die Leistungsfähigkeit der Lithographie erkennt man an der minimalen Streifenbreite der Strukturen, die mit ihr zu erreichen ist: Lichtlithographie $\approx$ 2 bis 3 µm, Elektronenstrahllithographie $\approx$ 0,05 bis 0,1 µm, Röntgenstrahllithographie und Ionenstrahllithographie < 150 nm.

Für alle Verfahren mit hoher Auflösung sind genaue und äußerst präzise definierte Masken erforderlich. Derartige Masken bestehen aus dem Muster der herzustellenden Struktur aus einem für die eingesetzte Lithographiestrahlung undurchlässigen Material (im weiteren Absorbermuster genannt), wobei das Absorbermuster auf einer dünnen Membran aus einem für die Lithographiestrahlung möglichst hochtransparenten Material angebracht ist.

Einige Materialien, die für Membranen angewendet werden und in bezug auf für Masken erforderliche Eigenschaften wie Maßhaltigkeit und Bruchstabilität außerordentlich gut geeignet sind, wie z.B. Metalle wie Titan, Beryllium oder Magnesium, sind zwar für kurzwellige Lithographiestrahlung, z.B. Röntgenstrahlen, hinreichend transparent, sie sind jedoch opak, d.h. undurchlässig für sichtbares Licht. Dies wirkt sich als Nachteil aus für die Justierung derartiger Masken, die heutzutage überwiegend mit Laserlicht vorgenommen wird.

Aus DE-AS 2 520 147 war eine Bestrahlungsmaske für Röntgenstrahllithographie bekannt, die eine Membran aus mit Bor dotiertem Silicium aufweist und in welcher Justierfenster aus $SiO_2$ gebildet sind. Derartige Masken haben sich als extrem bruchempfindlich erwiesen und waren aus diesem Grund für eine moderne Großserienfertigung nur schlecht geeignet. Die Fachwelt ist deshalb zu Belichtungsmasken übergegangen, die eine größere Stabilität gegenüber Bruch aufweisen, nämlich auf Masken mit Metallmembranen. Eine solche Maske mit einer Metallmembran aus z.B. Beryllium ist aus GB-A 2 089 524 bekannt. Ein genereller Nachteil der bekannten Masken mit Metallmembranen liegt darin, daß sie nicht vollautomatisch über Laserlicht justierbar sind.

In Journal of the Electrochemical Society, Solid State Science and Technology, 1981, May, Seite 1106 bis 1120, ist z.B. für eine Maske für Röntgenstrahllithographie eine Titanmembran beschrieben, für die, da sie für sichtbares Licht nicht transparent ist, ein indirektes Justierverfahren vorgeschlagen wird. Dieses indirekte Justierverfahren ist aufwendig und aufgrund der nur geringen Genauigkeit lediglich für relativ große Muster anwendbar.

Der Erfindung liegt die Aufgabe zugrunde, für Masken der eingangs genannten Art Membranen aus Metall, die für sichtbares Licht undurchlässig sind, so zu verbessern, daß sie vollautomatisch und direkt mit Hilfe von Laserlicht justiert werden können.

Diese Aufgabe wird erfindungsgemäß dadurch gelöst, daß die Membran Justierfenster aus einem für sichtbares Licht durchlässigen Kunststoff aufweist.

Nach vorteilhaften Weiterbildungen der Erfindung bestehen die Membran aus Titan und die Justierfenster aus einem Polyimid. Da Polyimide sowohl als Kunstharze als auch als Halbfabrikate wie Folien vorliegen, eröffnen sich an die jeweiligen Praxisanforderungen variabel anpaßbare Verarbeitungsmöglichkeiten.

Verfahren zur Herstellung der erfindungsgemäßen Maske sind durch unterschiedliche Verfahrensschritte gemäß den Ansprüchen 5 bis 9 gekennzeichnet. Vorteilhafte Weiterbildungen der Verfahren sind in den Unteransprüchen 10 bis 16 beschrieben.

Nach einer ersten Gruppe von Verfahren kann eine Membran mit einem Kunststoff in Form eines Kunstharzes, z.B. Polyimid, als Material für die Justierfenster beschichtet werden. Hiermit ist der Vorteil verbunden, daß Eigenschaften der Membran entsprechend unterschiedlichen gewünschten Praxisanforderungen durch anpaßbare Herstellungsverfahren für die Membran zunächst eingestellt werden können, bevor auf ihr die Kunstharzschicht als Membran angebracht wird.

Es kann gemäß einer zweiten Gruppe von Verfahren jedoch auch von einer als Halbfabrikat im Handel erhältlichen Folie aus einem Kunststoff, z.B. Polyimid, ausgegangen werden, die mit dem Material zur Ausbildung der Membran beschichtet wird, z.B. durch Kathodenzerstäubung. Mit diesem Vorgehen ist der Vorteil verbunden, daß eine Reihe von Verfahrensschritten eingespart werden können, die für das Verbinden von Membran und Kunststoff notwendig sind, wenn ein flüssiges Kunstharz verarbeitet wird. Die Verwendung des Kunststoffes in Form von Kunstharz oder aber auch in Form einer Folie ist also entsprechend unterschiedlichen Praxisanforderungen optimal auszuwählen.

Die mit der Erfindung erzielten Vorteile bestehen insbesondere darin, daß als Membran für eine Maske der eingangs genannten Art eine Metallmembran, die eine große Stabilität gegenüber Bruch hat, die aber auch z.B. gegenüber Röntgenstrahlung stabil ist, eingesetzt werden kann, wobei eine direkte, vollautomatische Justierung über Laserlicht erfolgen kann, was bisher bei Metallmembranen nicht möglich war. Ein besonderer Vorteil ist, daß mit den erfindungsgemäßen Verfahren zur Herstellung der Maske eine extrem hohe Lagegenauigkeit der Justierfiguren bei gleichzeitiger Minimierung der Justierfenstergröße erreichbar ist.

Anhand der Zeichnung werden Ausführungsbeispiele der erfindungsgemäßen Maske und der erfindungsgemäßen Verfahren zur Herstellung einer solchen Maske beschrieben und ihre Wirkungsweise erläutert.

Es zeigen:

Fig. 1a bis 1c Maske mit Justierfenstern gemäß der Erfindung im Schnitt in einigen Stufen ihrer Fertigstellung,

Fig. 2a bis 2c Maske mit Justierfenstern und Justiergruben gemäß der Erfindung im Schnitt in einigen Stufen ihrer Fertigstellung.

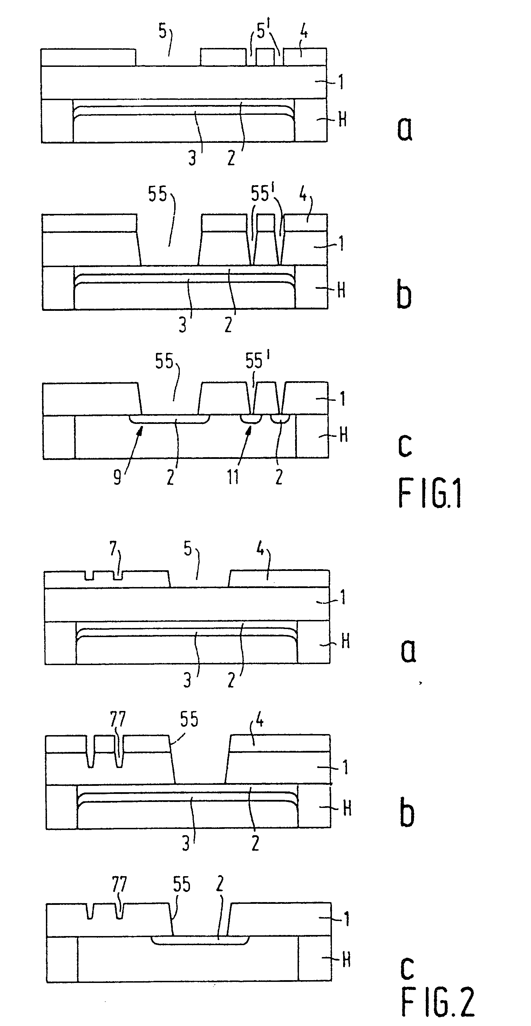

In den Figuren 1a bis 1c und 2a bis 2c sind jeweils Membranen 1 aus Titan im Schnitt dargestellt. Diese Membranen können auf unterschiedliche Weise erhalten worden sein. Z.B. kann auf ein Glassubstrat zunächst eine auf Glas schlecht haftende Goldschicht aufgebracht werden, und auf die Goldschicht wird dann eine Titanschicht aufgedampft. Die Membran wird anschließend mitsamt der Goldschicht vom Glassubstrat abgezogen und zur Weiterverarbeitung in bekannter Weise über einen Halterahmen gespannt.

Vorteilhafte Ergebnisse werden erhalten, wenn die Titanschicht nicht aufgedampft, sondern durch einen Kathodenzerstäubungsprozeß auf die auf dem Glassubstrat befindliche Goldschicht aufgebracht wird.

Zur Ausbildung der Membran kann nach einem anderen Verfahren auch so vorgegangen werden, daß das Material der Membran, also Titan, direkt auf eine, in einem späteren Verfahrensschritt zur Ausbildung der Justierfenster verwendete, im Handel erhältliche Polyimidfolie aufgebracht wird. Das Aufbringen kann z.B. ebenfalls durch Kathodenzerstäubung erfolgen.

Verfahren A

Mit einer Membran 1, die, wie oben beschrieben, durch Kathodenzerstäubung auf einem Glassubstrat erhalten, abgezogen und über einen Halterahmen H gespannt wurde, wird gemäß den Fig. 1a bis 1c nun wie folgt weitergearbeitet: Auf eine der Hauptflächen der Membran 1 aus Titan wird zunächst eine etwa 0,5 µm dicke Polyimidschicht 2 durch Aufschleudern aufgebracht. Es ist zweckmäßig, diese Polyimidschicht zu stabilisieren; dies kann durch einen Temperprozeß über 4 h bei einer Temperatur von etwa 200 °C erfolgen.

Auf die Polyimidschicht 2 wird anschließend eine etwa 0,5 µm dicke Schicht 3 aus einem negativ arbeitenden, UV-empfindlichen Photolack aufgebracht. Auf die andere Hauptfläche der Membran 1 wird eine etwa 1,3 µm dicke Schicht 4 aus einem positiv arbeitenden Photolack aufgebracht. Beide Photolackschichten 3, 4 werden anschließend durch einen Temperprozeß über 0,5 h bei einer Temperatur von etwa 90 °C stabilisiert.

Anschließend wird die positiv arbeitende Photolackschicht 4 entsprechend dem in ihr auszubildenden Muster für die Justierfenster belichtet. In dem in Fig. 1a gezeigten Beispiel wurden in der Photolackschicht 4 eine Öffnung 5 sowie mehrere kleinere Öffnungen 5' geöffnet.

Über die in der Photolackschicht 4 angebrachten Öffnungen 5 und 5' kann in einem anschließenden Verfahrensschritt die unter der Photolackschicht 4 liegende Membran 1 aus Titan zur Ausbildung von Justierfenstern 55, 55' geätzt werden. Dies kann z.B. mit einem naßchemischen Ätzprozeß erfolgen. Eine geeignete Ätzlösung besteht dabei aus einem Verhältnis $0,6 \, Hf : 2,4 \, HNO_3 : 96 \, H_2O : 1 \, H_2O_2$.

Die Membran 1 kann auch über einen reaktiven Ionenätzprozeß mit folgenden Parametern geätzt werden:

HF-Generator: 27,5 MHz;
Elektrodendurchmesser: 200 mm;
Potential an der Kathode: 30 V;
Arbeitsdruck der Gasatmosphäre: $CCl_4 = 3,9$ Pa.

Statt einer reaktiven Ionenätzung kann z.B. auch eine Plasmaätzung durchgeführt werden.

Auf diese Weise kann die in Fig. 1b dargestellte Struktur erreicht werden.

Die kleineren Justierfenster 55' können als Justierfiguren für einen in einem späteren Prozeßschritt einzusetzenden Elektronenstrahlschreiber verwendet werden. Durch die Justierfenster 55' kann die Lage der später aufzubringenden Justier- und Absorberfiguren der Maske für eine Röntgenstrahlbelichtung exakt in bezug auf die Justierfenster 55 festgelegt werden, so daß ein Höchstmaß an Flächenausnutzung der über die Maske zu belichtenden Substrate gewährleistet wird.

Durch die in der Membran 1 auf die oben beschriebene Weise erzeugten Justierfenster 55 und 55' hindurch wird die unterhalb der für sichtbares Licht durchlässigen Schicht 2 liegende Photolackschicht 3 aus negativ arbeitendem Photolack mittels UV-Strahlung belichtet und in diesen Bereichen vernetzt. Die Membran 1 wirkt dabei als selbstjustierende Maske. Der negativ arbeitende Photolack wird bei dem Belichtungsprozeß mit UV-Strahlung auch in einem durch die Dicke der für sichtbares Licht durchlässigen Schicht 2 und den Abstand der UV-Strahlungsquelle festgelegten Schattenbereich vernetzt. Anschließend wird die Photolackschicht 13 entwickelt. In einem folgenden Prozeßschritt wird die für sichtbares Licht durchlässige Schicht 2 durch reaktive Ionenätzung unter Sauerstoffeinfluß in den Bereichen, die nicht von der verbliebenen Photolackschicht 3 bedeckt sind, entfernt, wobei mit Vorteil eine $O_2$-Atmosphäre angewendet werden kann. Nach diesem Ätzschritt verbleiben unter den Justierfenstern 55, 55' Inseln 9, 11 der für sichtbares Licht durchlässigen Schicht 2 (vgl. Fig. 1c).

Die unter den Justierfenstern 55, 55' liegenden Inseln 9, 11 der für sichtbares Licht durchlässigen Schicht 2 aus Polyimid werden anschließend einer Synchrotronstrahlung einer Dosis ausgesetzt, die etwa um den Faktor 12 größer als die für die Belichtung von üblicherweise eingesetztem PMMA-Lack erforderliche Dosis ist. Die Bestrahlung mit Synchrotronstrahlung ist zweckmäßig, um das Polyimid gegenüber Röntgenstrahlung zu stabilisieren.

Nach Entfernen der neben den Öffnungen 5 und 5' für die Justierfenster liegenden Bereiche der Photolackschicht 4 wird auf der Membran 1 das gewünschte Absorbermuster ausgebildet. Das Verfahren zur Herstellung dieses Absorbermusters wird weiter unten beschrieben.

Verfahren B

Nach einem abgewandelten Verfahren zur Herstellung der beanspruchten Maske wird so verfahren, daß auf die Membran 1 aus Titan, die über den Halterahmen H gespannt ist, auf die oben beschriebene Weise die Polyimidschicht 2, die Photolackschicht 3 aus negativ arbeitendem Photolack und die Photolackschicht 4 aus positiv arbeitendem Photolack aufgebracht werden (vgl. Fig. 2a bis 2c).

Zur Ausbildung der Öffnungen 5 und von Öffnungen 7 in der Photolackschicht 4 wird nun jedoch kein photolithographischer Prozeß, sondern ein elektronenstrahllithographischer Prozeß angewendet. Es wird dabei so verfahren, daß die Photolackschicht 4 mit einem Elektronenstrahl belichtet wird, dem im Bereich der auszubildenden Öffnungen 7 eine etwa um 60% verringerte Stromdichte erteilt wird gegenüber der vollen Stromdichte für die Belichtung der Bereiche der Photolackschicht 4, in denen die Öffnungen 5 ausgebildet werden sollen. Damit wird in den schwächer belichteten Bereichen nur etwa die Hälfte der Schichtdicke des Photolacks bei der anschließenden Entwicklung abgetragen.

Nach Entfernen der belichteten Bereiche der Photolackschicht 4 schließt sich ein Ätzprozeß für die Membran 1 aus Titan an, wie er für das Verfahren A beschrieben wurde. Dabei werden die Justierfenster 55 vollständig, Justiergruben 77 dagegen nur halb durchgeätzt.

Die weiteren Verfahrensschritte zur Fertigstellung der Maske erfolgen analog den für Verfahren A beschriebenen Prozeßschritten.

Verfahren C

Nach einem weiteren abgewandelten Verfahren zur Herstellung der beanspruchten Maske wird so vorgegangen, daß, wie bei den Verfahren A und B beschrieben, auf die eine Hauptfläche der Membran 1 aus Titan, die über einen Halterahmen H gespannt ist, auf die oben beschriebene Weise die Schicht aus für sichtbares Licht durchlässigem Material 2 aus Polyimid aufgebracht und durch Tempern bei einer Temperatur von 200 °C über eine Dauer von 4 h stabilisiert wird. Anschließend wird, abweichend zu den vorbeschriebenen Verfahren A und B, nur die positiv arbeitende Photolackschicht 4 auf die andere Hauptfläche der Membran 1 aufgebracht; auf das Anbringen einer negativ arbeitenden Photolackschicht wird verzichtet. Die positiv arbeitende Photolackschicht 4 wird ebenfalls, wie oben beschrieben, durch Tempern bei einer Temperatur von etwa 90 °C über eine Dauer von etwa 0,5 h stabilisiert.

Mittels eines photolithographischen Prozesses wird die Photolackschicht 4 in den Bereichen der herzustellenden Justierfenster geöffnet, und anschließend werden in der Membran 1 die Justierfenster 55, 55' mittels einer Plasmaätzung oder mittels einer reaktiven Ionenätzung, wie unter Verfahren A beschrieben, ausgeätzt.

Im Anschluß an diesen Ätzschritt wird die gesamte Schicht aus für sichtbares Licht durchlässigem Material 2, Polyimid, wie unter Verfahren A beschrieben, mit Synchrotronstrahlung stabilisiert. Bei dem hier beschriebenen Verfahren werden also keine unter den Justierfenstern liegenden, voneinander getrennten Inseln aus Polyimid ausgebildet, sondern die gesamte Polyimidschicht unter der Membran bleibt erhalten.

Nach Entfernen der positiv arbeitenden Photolackschicht 4 von der Membran 1 wird auf dieser das gewünschte Absorbermuster, wie weiter unten beschrieben ist, ausgebildet.

Verfahren D

In Abwandlung der oben beschriebenen Verfahren A bis C kann zur Herstellung der beanspruchten Maske auch so vorgegangen werden, daß das die Membran 1 bildende Material, Titan, auf einer im Handel als Halbfabrikat erhältlichen Polyimidfolie als der für sichtbares Licht durchlässigen Schicht 2 durch Kathodenzerstäubung nach dem bereits oben beschriebenen Verfahren angebracht wird. In weiteren Verfahrensschritten werden dann auf der Polyimidfolie eine Photolackschicht 3 aus negativ arbeitendem Photolack und auf der als Membran 1 vorgesehenen Titanschicht eine Photolackschicht 4 aus positiv arbeitendem Photolack angebracht. Beide Photolackschichten 3, 4 werden anschließend durch einen Temperprozeß bei einer Temperatur von etwa 90 °C über etwa 30 min stabilisiert.

Die Photolackschicht 4 aus positiv arbeitendem Photolack wird über eine Maske im Bereich der auszubildenden Justierfenster mit UV-Strahlung bestrahlt, und die bestrahlten Bereiche werden anschließend zur Herstellung der Öffnungen 5, 5' für die Justierfenster 55, 55' entfernt. Durch einen anschließenden Ätzprozeß werden die Justierfenster 55, 55' in der Membran 1 in Form der Titanschicht geöffnet. Es können hierzu die unter Verfahren A beschriebenen Ätzprozesse eingesetzt werden. Die Membran 1 wird hierbei in allen Justierfensterbereichen völlig durchgeätzt.

Anschließend wird die Photolackschicht 3 aus negativ arbeitendem Photolack durch die Justierfenster 55, 55' hindurch in der unter Verfahren A bereits beschriebenen Weise mit divergenter UV-Strahlung bestrahlt und damit vernetzt. Die nicht vernetzten Bereiche der Photolackschicht werden entwickelt. Die außerhalb der Justierfenster liegenden Bereiche der Polyimidfolie können anschließend durch einen reaktiven Ionenätzprozeß

auf die unter Verfahren A beschriebene Weise abgeätzt werden.

Die unter den Justierfenstern 55, 55' verbliebenen Polyimidinseln werden anschließend ebenfalls, wie unter Verfahren A beschrieben, stabilisiert.

Nach Entfernen der positiv arbeitenden Photolackschicht 4 von der Trägermembran 1 wird auf dieser das gewünschte Absorbermuster mit den weiter unten beschriebenen Verfahrensschritten ausgebildet.

Verfahren E

In Abwandlung des oben beschriebenen Verfahrens D werden unter Anwendung einer im Handel als Halbfabrikat erhältlichen Polyimidfolie, auf die die als Membran 1 vorgesehene Titanschicht aufgebracht wurde, wie unter Verfahren B beschrieben, Justierfenster 55 ausgebildet in Form von vollständig durchgeätzten Titanschichtbereichen. Gleichzeitig werden Justiergruben 77 ausgebildet, die in Form von nur etwa über die Hälfte ihrer Schichtdicke abgeätzten Titanschichtbereichen vorliegen.

Die nur über die Hälfte ihrer Schichtdicke durchgeätzten Justiergruben 77 in der Titanschicht als Membran 1 werden eingesetzt, wenn das Absorbermuster mit Hilfe eines Elektronenstrahlschreibers erzeugt werden soll. Die Justiergruben dienen für den Elektronenstrahl als Bezugsmarken, damit die Lage der später zu erzeugenden Justiermarken in den Justierfenstern exakt zu den Justierfenstern definiert wird.

Die nicht vollständig durchgeätzten Justiergruben haben den Vorteil, daß sie einerseits als Justierhilfe für einen Elektronenstrahl dienen können, andererseits die Membran mechanisch jedoch relativ stabil bleibt, da die Gruben nicht durchgehend sind.

Bei der Herstellung einer derartigen Maske wird analog zu den Verfahren B und D so vorgegangen, daß zunächst eine im Handel erhältliche Polyimidfolie als für sichtbares Licht durchlässige Schicht 2 mit einer Titanschicht auf einer ihrer Hauptflächen bedeckt wird, die die Funktion der Membran 1 hat. Die Titanschicht kann, z.B. auch als spannungskompensierte Mehrschichtenfolge, auf die Polyimidfolie durch Kathodenzerstäubung aufgebracht werden. Anschließend werden auf die andere Hauptfläche der Polyimidfolie eine Photolackschicht 3 aus einem negativ arbeitenden Photolack und auf die Oberseite der Titanschicht eine Photolackschicht 4 aus einem positiv arbeitenden Photolack aufgebracht. Beide Photolackschichten werden stabilisiert durch einen Temperprozeß bei einer Temperatur von etwa 90 °C über eine Dauer von etwa 30 min.

Es schließt sich ein elektronenstrahllithographischer Prozeß zur Ausbildung der Öffnungen 5, 7 in der Photolackschicht 4 an.

Anschließend an den Ätzschritt zur Ausbildung der Justierfenster 55 und der Justiergruben 77 wird die unterhalb der Polyimidfolie befindliche Photolackschicht 3 aus einem negativ arbeitenden Photolack durch die vollständig geöffneten Justierfenster 55 hindurch mit Strahlung einer divergenten UV-Strahlungsquelle bestrahlt und dabei vernetzt. Es schließt sich ein Entwicklungsprozeß für den Photolack an. Danach folgt ein Plasma- oder reaktiver Ionenstrahlätzprozeß, bei welchem die Bereiche der Polyimidfolie, die außerhalb der durchgehenden Justierfenster 55 liegen, abgeätzt werden. Die verbleibenden Bereiche der Polyimidschicht unterhalb der Justierfenster 55 werden, wie unter Verfahren A beschrieben, stabilisiert.

Nach Entfernen der positiv arbeitenden Photolackschicht von der Membran 1 wird auf dieser das gewünschte Absorbermuster der herzustellenden Maske erzeugt.

Als sehr geeignet haben sich hierfür mehrschichtige Absorberschichten, z.B. aus Wolfram und Molybdän, erwiesen. Hierzu kann wie folgt verfahren werden: Sowohl die Wolfram- als auch die Molybdän-Schicht werden durch Kathodenzerstäubung angebracht. Die Wolfram-Schicht wird zweckmäßigerweise mit folgenden Parametern angebracht:

| | |
|---|---|
| HF-Generator | 13,6 MHz; |
| Elektrodendurchmesser | 200 mm; |
| Abstand der Elektroden | 42 mm; |
| Arbeitsdruck der Gasatmosphäre | Ar = 2 Pa; |
| Potential an der Elektrode | 800 V; |
| Potential am Maskenträger | 40 V. |

Die Molybdänschicht kann durch Kathodenzerstäubung unter folgenden Bedingungen angebracht werden:

| | |
|---|---|
| HF-Generator | 13,6 MHz; |
| Elektrodendurchmesser | 200 mm; |
| Abstand der Elektroden | 42 mm; |
| Arbeitsdruck der Gasatmosphäre | Ar = 2 Pa; |
| Potential an der Elektrode | 700 V; |
| Potential am Maskenträger | 95 V. |

Die Strukturierung dieser Absorberschicht gemäß dem gewünschten Maskenmuster kann mit Hilfe bekannter Techniken, z.B. mit Hilfe der Elektronenstrahllithographie, ausgeführt werden.

Patentansprüche

1. Maske für die Mustererzeugung in Lackschichten mittels Röntgenstrahllithographie mit einer für sichtbares Licht undurchlässigen Membran aus Metall und mit einer, auf einer der Hauptflächen der Membran befindlichen, die Röntgenstrahlung absorbierenden, entsprechend dem zu erzeugenden Muster strukturierten Schicht (Absorbermuster), dadurch gekennzeichnet, daß die Membran (1) Justierfenster (55, 55') aus einem für sichtbares Licht durchlässigen Kunststoff aufweist.

2. Maske nach Anspruch 1, dadurch gekennzeichnet, daß die Membran (1) aus Titan besteht.

3. Maske nach den Ansprüchen 1 und 2, dadurch gekennzeichnet, daß die Justierfenster (55, 55') aus einem Polyimid bestehen.

4. Maske nach mindestens einem der Ansprüche 1 bis 3, dadurch gekennzeichnet, daß in der Membran (1) neben den Justierfenstern (55, 55'), in denen das Material der Membran vollständig entfernt ist, Justiergruben (77) vorgesehen sind, in denen das Material der Membran nur etwa bis zur Hälfte seiner Schichtdicke entfernt ist.

5. Verfahren zur Herstellung der Maske nach den Ansprüchen 1 bis 4, dadurch gekennzeichnet, daß in der Membran Justierfenster aus einem für sichtbares Licht durchlässigen Kunststoff angebracht werden mit folgenden Verfahrensschritten:

a) Aufbringen einer Schicht aus einem für sichtbares Licht durchlässigen Kunststoff auf einer der Hauptflächen der Membran

b) Aufbringen einer negativ arbeitenden Photolackschicht auf die für sichtbares Licht durchlässige Schicht

c) Aufbringen einer positiv arbeitenden Photolackschicht auf die andere Hauptfläche der Membran

d) Stabilisierung der beiden Photolackschichten durch Tempern

e) Belichtung der positiv arbeitenden Photolackschicht in den Bereichen der vorgesehenen Justierfenster

f) Entfernen der positiv arbeitenden Photolackschicht in den Bereichen der vorgesehenen Justierfenster

g) Entfernen der Membran in den von der positiv arbeitenden Photolackschicht freigelegten Bereichen durch einen Ätzschritt zur Ausbildung der Justierfenster

h) Polymerisierung der negativ arbeitenden Photolackschicht im Bereich der Justierfenster

j) Entfernen der nicht vernetzten Bereiche der negativ arbeitenden Photolackschicht durch Entwicklung sowie der für sichtbares Licht durchlässigen Schicht in den Bereichen, die außerhalb der Justierfenster liegen, durch einen Ätzschritt

k) Entfernen der positiv arbeitenden Photolackschicht von der Membran

l) Stabilisierung der für sichtbares Licht durchlässigen Schicht durch Röntgenstrahlung

m) Ausbildung des gewünschten Absorbermusters auf der den Inseln aus für sichtbares Licht durchlässigen Kunststoff gegenüberliegenden Hauptfläche der Membran.

6. Verfahren zur Herstellung der Maske nach den Ansprüchen 1 bis 4, dadurch gekennzeichnet, daß in der Membran Justierfenster aus einem für sichtbares Licht durchlässigen Kunststoff sowie Justiergruben angebracht werden mit folgenden Verfahrensschritten:

a) Anbringen einer Schicht aus einem für sichtbares Licht durchlässigen Kunststoff auf einer der Hauptflächen der Membran

b) Anbringen einer negativ arbeitenden Photolackschicht auf der für sichtbares Licht durchlässigen Schicht

c) Anbringen einer positiv arbeitenden Photolackschicht auf der anderen Hauptfläche der Membran

d) Stabilisierung der beiden Photolackschichten durch Tempern

e) elektronenstrahllithographischer Prozeß zur teilweisen Entfernung der positiv arbeitenden Photolackschicht in den Bereichen der vorgesehenen Justiergruben und/oder zur vollständigen Entfernung der positiv arbeitenden Photolackschicht in den Bereichen der vorgesehenen Justierfenster

f) teilweise und/oder vollständige Entfernung der Membran in den Bereichen der vorgesehenen Justiergruben/Justierfenster durch einen Ätzschritt

g) Polymerisierung der negativ arbeitenden Photolackschicht im Bereich der Justierfenster

h) Entfernen der nicht vernetzten Bereiche der negativ arbeitenden Photolackschicht durch Belichtung sowie der für sichtbares Licht durchlässigen Schicht in den Bereichen, die außerhalb der Justierfenster liegen, durch einen Ätzschritt

j) Entfernen der positiv arbeitenden Photolackschicht von der Membran

k) Stabilisierung der für sichtbares Licht durchlässigen Schicht durch Röntgenstrahlung

l) Ausbildung des gewünschten Absorbermusters auf der der für sichtbares Licht durchlässigen Schicht gegenüberliegenden Hauptfläche der Membran.

7. Verfahren zur Herstellung der Maske nach den Ansprüchen 1 bis 4, dadurch gekennzeichnet, daß in der Membran Justierfenster aus einem für sichtbares Licht durchlässigen Kunststoff angebracht werden mit folgenden Verfahrensschritten:

a) Anbringen einer Schicht aus dem für sichtbares Licht durchlässigen Kunststoff auf einer der Hauptflächen der Membran

b) Anbringen einer positiv arbeitenden Photolackschicht auf der anderen Hauptfläche der Membran

c) Stabilisierung der Photolackschicht durch Tempern

d) Belichtung der positiv arbeitenden Photolackschicht in den Bereichen der vorgesehenen Justierfenster

e) Entfernen der positiv arbeitenden Photolackschicht in den Bereichen der vorgesehenen Justierfenster

f) Entfernen der Membran in den von der positiv arbeitenden Photolackschicht freigelegten Bereichen durch einen Ätzschritt zur Ausbildung der Justierfenster

g) Entfernen der positiv arbeitenden Photolackschicht von der Membran

h) Stabilisierung der für sichtbares Licht durchlässigen Schicht durch Röntgenstrahlung

j) Ausbildung des gewünschten Absorbermusters auf der der Schicht aus für sichtbares Licht durchlässigen Kunststoff gegenüberliegenden Hauptfläche der Membran.

8. Verfahren zur Herstellung der Maske nach den Ansprüchen 1 bis 4, dadurch gekennzeichnet, daß in der Membran Justierfenster aus einem für sichtbares Licht durchlässigen Kunststoff angebracht werden mit folgenden Verfahrensschritten:

a) Die Membran wird als dünne Schicht auf einer der Hauptflächen einer für sichtbares Licht durchlässigen Folie angebracht

b) Anbringen einer negativ arbeitenden Photolackschicht auf der anderen Hauptfläche der für sichtbares Licht durchlässigen Folie

c) Anbringen einer positiv arbeitenden Photolackschicht auf der als Membran vorgesehenen dünnen Schicht

d) Stabilisierung der beiden Photolackschichten durch Tempern

e) Belichtung der positiv arbeitenden Photolackschicht in den Bereichen der vorgesehenen Justierfenster

f) Entfernen der positiv arbeitenden Photolackschicht in den Bereichen der vorgesehenen Justierfenster

g) Entfernen der Membran in den von der positiv arbeitenden Photolackschicht freigelegten Bereichen durch einen Ätzschritt zur Ausbildung der Justierfenster

h) Polymerisierung der negativ arbeitenden Photolackschicht im Bereich der Justierfenster

j) Entfernen der nicht vernetzten Bereiche der negativ arbeitenden Photolackschicht durch Entwicklung sowie der für sichtbares Licht durchlässigen Folie in den Bereichen, die außerhalb der Justierfenster liegen, durch einen Ätzschritt

k) Entfernen der positiv arbeitenden Photolackschicht von der Membran

l) Stabilisierung der für sichtbares Licht durchlässigen Folie durch Röntgenstrahlung

m) Ausbildung des gewünschten Absorbermusters auf der den Inseln aus für sichtbares Licht durchlässigem Kunststoff gegenüberliegenden Hauptfläche der Membran.

9. Verfahren zur Herstellung der Maske nach den Ansprüchen 1 bis 4, dadurch gekennzeichnet, daß in der Membran Justierfenster aus einem für sichtbares Licht durchlässigen Kunststoff sowie Justiergruben angebracht werden mit folgenden Verfahrensschritten:

a) Die Membran wird als dünne Schicht auf einer der Hauptflächen einer für sichtbares Licht durchlässigen Folie angebracht

b) Anbringen einer negativ arbeitenden Photolackschicht auf der anderen Hauptfläche der für sichtbares Licht durchlässigen Folie

c) Anbringen einer positiv arbeitenden Photolackschicht auf der als Membran vorgesehenen dünnen Schicht

d) Stabilisierung der beiden Photolackschichten durch Tempern

e) elektronenstrahllithographischer Prozeß zur teilweisen Entfernung der positiv arbeitenden Photolackschicht in den Bereichen der vorgesehenen Justiergruben und/oder zur vollständigen Entfernung der positiv arbeitenden Photolackschicht in den Bereichen der vorgesehenen Justierfenster

f) teilweise und/oder vollständige Entfernung der Membran in den Bereichen der vorgesehenen Justiergruben/Justierfenster durch einen Ätzschritt

g) Polymerisierung der negativ arbeitenden Photolackschicht im Bereich der Justierfenster

h) Entfernen der nicht vernetzten Bereiche der negativ arbeitenden Photolackschicht durch Entwicklung sowie der für sichtbares Licht durchlässigen Folie in den Bereichen, die außerhalb der Justierfenster liegen, durch einen Ätzschritt

j) Entfernen der positiv arbeitenden Photolackschicht von der Membran

k) Stabilisierung der für sichtbares Licht durchlässigen Folie durch Röntgenstrahlung

l) Ausbildung des gewünschten Absorbermusters auf der der für sichtbares Licht durchlässigen Folie gegenüberliegenden Hauptfläche der Membran.

10. Verfahren nach mindestens einem der Ansprüche 5 bis 9, dadurch gekennzeichnet, daß als Material für die Membran Titan eingesetzt wird.

11. Verfahren nach mindestens einem der Ansprüche 5 bis 9, dadurch gekennzeichnet, daß als für sichtbares Licht durchlässiger Kunststoff ein Polyimid eingesetzt wird.

12. Verfahren nach den Ansprüchen 5 bis 7, 11, 13, dadurch gekennzeichnet, daß das Polyimid in Form eines Kunstharzes als Schicht angebracht wird.

13. Verfahren nach mindestens einem der Ansprüche 8, 9 und 11, dadurch gekennzeichnet, daß das Polyimid als Halbzeug in Form einer Folie verarbeitet wird.

14. Verfahren nach mindestens einem der Ansprüche 5 bis 9, dadurch gekennzeichnet, daß die Membran durch Abscheiden mehrerer, sandwichartig übereinander geschichteter Einzelschichten unterschiedlicher Zug- oder Druckspannung auf einem Substrat hergestellt und anschließend von diesem Substrat abgelöst wird.

15. Verwendung der Maske nach den Ansprüchen 1 bis 14 zur Herstellung von Halbleiteranordnungen.

16. Verwendung der Maske nach den Ansprüchen 1 bis 14 zur Herstellung von magnetischen Zylinderdomänenanordnungen.

**Claims**

1. A mask for producing patterns in lacquer layers by means of X-raylithography comprising a diaphragm of metal opaque to visible light and a layer (absorber pattern) present on one of the major surfaces of the diaphragm, absorbing the X-ray radiation and structured in accordance with the pattern to be produced, characterized in that the diaphragm (1) has adjustment windows (55, 55') of a material transparent to visible light.

2. A mask as claimed in Claim 1, characterized in that the diaphragm (1) consists of titanium.

3. A mask as claimed in Claims 1 and 2, characterized in that the adjustment windows (55, 55') consist of a polyimide.

4. A mask as claimed in at least one of Claims 1 to 3, characterized in that the diaphragm (1) is provided beside the adjustment windows (55, 55'), in which the material of the diaphragm has been completely removed, with adjustment depressions (77), in which the material of the diaphragm has been removed only as far about half its layer thickness.

5. A method of manufacturing the mask claimed in Claims 1 to 4, characterized in that adjustment windows of a material transparent to visible light are provided in the diaphragm by means of the following processing steps:

a) applying a layer of a synthetic material transparent to visible light to one of the major surfaces of the diaphragm;

b) applying a negatively working photolacquer layer to the layer transparent to visible light;

c) applying a positively working photolacquer layer to the other major surface of the diaphragm;

d) stabilizing both lacquer layers by tempering;

e) exposure of the positively working photolacquer layer at the areas of the adjustment windows provided;

f) removing the positively working photolacquer layer at the areas of the adjustment windows provided;

g) removing the diaphragm at the areas freed from the positively working photolacquer layer by an etching step for forming the adjustment windows;

h) polymerizing the negatively working photolacquer layer at the area of the adjustment windows;

j) removing the non-cross-linked parts of the negatively working photolacquer layer by development as well as the layer transparent to visible light at the areas located outside the adjustment windows by an etching step;

k) removing the positively working photolacquer layer from the diaphragm;

l) stabilizing the layer transparent to visible light by X-ray radiation;

m) forming the desired absorber pattern on the major surface of the diaphragm located opposite the islands of material transparent to visible light.

6. A method of manufacturing the mask claimed in Claims 1 to 4, characterized in that adjustment windows of a synthetic material transparent to visible light and adjustment depressions are provided in the diaphragm by means of the following processing steps:

a) applying a layer of a synthetic material transparent to visible light to one of the major surfaces of the diaphragm;

b) applying a negatively working photolacquer layer to the layer transparent to visible light;

c) applying a positively working photolacquer layer to the other major surface of the diaphragm;

d) stabilizing the two photolacquer layers by tempering;

e) electron-beam lithographic process for partially removing the positively working photolacquer layer at the areas of the adjustment depressions provided and/or for completely removing the positively working photolacquer layer at the areas of the adjustment windows provided;

f) partially and/or completely removing the diaphragm at the areas of the adjustment depressions/adjustment windows provided by means of an etching step;

g) polymerizing the negatively working photolacquer layer at the area of the adjustment windows;

h) removing the non-cross-linked regions of the negatively working photolacquer layer by exposure and the layer transparent to visible light at the areas located outside the adjustment windows by means of an etching step;

j) removing the positively working photolacquer layer from the diaphragm;

k) stabilizing the layer transparent to visible light by X-ray radiation;

l) forming the desired absorber pattern on the major surface of the diaphragm located opposite to the layer transparent to visible light.

7. A method of manufacturing the mask claimed in Claims 1 to 4, characterized in that adjustment windows of a synthetic material transparent to visible light are provided in the diaphragm by the following processing steps:

a) applying a layer from the synthetic material transparent to visible light to one of the major surfaces of the diaphragm,

b) applying a positively working photolacquer layer to the other major surface of the diaphragm,

c) stabilizing the photolacquer layer by tempering,

d) exposure of the positively working photolacquer layer at the areas of the adjustment windows provided,

e) removing the positively working photolacquer layer at the areas of the adjustment windows provided,

f) removing the diaphragm at the areas freed from the positively working photolacquer by an etching step for forming the adjustment windows,

g) removing the positively working photolacquer layer from the diaphragm,

h) stabilizing the layer transparent to visible light by X-ray radiation,

j) forming the desired absorber pattern on the major surface of the diaphragm arranged opposite to the layer of synthetic material transparent to visible light.

8. A method of manufacturing the mask claimed in Claims 1 to 4, characterized in that in the diaphragm adjustment windows are formed from a synthetic material transparent to visible light by the following processing steps:

a) the diaphragm is applied as a thin layer to one of the major surfaces of a foil transparent to visible light,

b) applying a negatively working photolacquer layer to the other major surface of the foil transparent to visible light,

c) applying a positively working photolacquer layer to the thin layer provided as a diaphragm,

d) stabilizing the two photolacquer layers by tempering,

e) exposure of the positively working photolacquer layer at the areas of the adjustment windows provided,

f) removing the positively working photolacquer layer at the areas of the adjustment windows provided,

g) removing the diaphragm at the areas freed from the positively working photolacquer layer by an etching step for forming the adjustment windows,

h) polymerizing the negatively working photolacquer layer at the area of the adjustment windows,

j) removing the non-cross-linked regions of the negatively working photolacquer layer by development and the foil transparent to visible light in the regions located outside the adjustment windows by an etching step,

k) removing the positively working photolacquer layer from the diaphragm,

l) stabilizing the foil transparent to visible light by X-ray radiation,

m) forming the desired absorber pattern on the major surface of the diaphragm arranged opposite to the islands of synthetic material transparent to visible light.

9. A method of manufacturing the mask claimed in Claims 1 to 4, characterized in that in the diaphragm adjustment windows from a synthetic material transparent to visible light and adjustment depressions are formed by the following processing steps:

a) the diaphragm is applied as a thin layer to one of the major surfaces of a foil transparent to visible light,

b) applying a negatively working photolacquer layer to the other major surface of the foil transparent to visible light,

c) applying a positively working photolacquer layer to the thin layer provided as a diaphragm,

d) stabilizing the two photolacquer layers by tempering,

e) electron beam lithographic process for partially removing the positively working photolacquer layer at the areas of the adjustment depressions provided and/or for completely removing the positively working photolacquer layer at the areas of the adjustment windows provided,

f) partially and/or completely removing the diaphragm at the areas of the adjustment depressions/adjustment windows provided by an etching step,

g) polymerizing the positively working photolacquer layer at the area of the adjustment windows,

h) removing the non-cross-linked regions of the negatively working photolacquer layer by development and the foil transparent to visible light at the areas located outside the adjustment windows by an etching step,

j) removing the positively working photolacquer layer from the diaphragm,

k) stabilizing the foil transparent to visible light by X-ray radiation,

l) forming the desired absorber pattern on the major surface of the diaphragm arranged opposite to the foil transparent to visible light.

10. A method as claimed in at least any one of Claims 5 to 9, characterized in that as material for the diaphragm titanium is used.

11. A method as claimed in at least any one of Claims 5 to 9, characterized in that as synthetic material transparent to visible light a polyimide is used.

12. A method as claimed in Claims 5 to 7, 11, characterized in that the polyimide is applied as a layer in the form of a synthetic resin.

13. A method as claimed in at least any one of Claims 8, 9 and 11, characterized in that the polyimide is processed as a semi-manufactured article in the form of a foil.

14. A method as claimed in at least one of Claims 5 to 9, characterized in that the diaphragm is formed by deposition of several individual layers overlaying each other as a sandwich structure and having different tensile or compressive stresses on a substrate and is then removed from this substrate.

15. Application of the mask claimed in Claims 1 to 14 for manufacturing semiconductor devices.

16. Application of the mask claimed in Claims 1 to 14, for manufacturing magnetic cylindrical domain arrangements.

**Revendications**

1. Masque pour former par lithographie par rayons X des motifs dans des couches de laque, masque qui comporte une membrane métallique opaque à la lumière visible et une couche située sur l'une des surfaces principales de la membrane et absorbant le rayonnement X, couche qui est structurée selon les motifs à former (motif absorbant), caractérisé en ce que la membrane (1) présente des fenêtres d'alignement (55, 55') en matière plastique transparente à la lumière visible.

2. Masque selon la revendication 1, caractérisé en ce que la membrane (1) est en titane.

3. Masque selon les revendications 1 et 2, caractérisé en ce que les fenêtres d'alignement (55, 55') sont en polyimide.

4. Masque selon au moins l'une des revendications 1 à 3, caractérisé en ce que, dans la membrane (1), à côté des fenêtres d'alignement (55, 55') dans lesquelles le matériau de la membrane est entièrement éliminé, il est prévu des sillons d'alignement (77) dans lesquels le matériau de la membrane n'est éliminé que sur la moitié de son épaisseur environ.

5. Procédé de fabrication du masque selon les revendications 1 à 4, caractérisé en ce qu'on forme dans la membrane des fenêtres d'alignement en matière plastique transparente à la lumière visible en effectuant les étapes de procédé suivantes:

a) le dépôt d'une couche de matière plastique transparente à la lumière visible sur l'une des surfaces principales de la membrane,

b) le dépôt d'une couche de photorésist à effet négatif sur la couche transparente à la lumière visible,

c) le dépôt d'une couche de photorésist à effet positif sur l'autre surface principale de la membrane,

d) la stabilisation des deux couches de photorésist par recuit,

e) l'exposition de la couche de photorésist à effet positif à l'endroit des fenêtres d'alignement prévues,

f) l'élimination de la couche de photorésist à effet positif à l'endroit des fenêtres d'alignement prévues,

g) l'élimination par attaque chimique de la membrane dans les parties mises à découvert de la couche de photorésist à effet positif pour former les fenêtres d'alignement,

h) la polymérisation de la couche de photorésist à effet négatif à l'endroit des fenêtres d'alignement,

j) l'élimination par développement des parties non réticulées de la couche de photorésist à effet négatif ainsi que l'élimination par attaque chimique de la couche transparente à la lumière visible dans les parties situées en dehors des fenêtres d'alignement,

k) l'élimination de la couche de photorésist à effet positif de la membrane,

l) la stabilisation de la couche transparente à la lumière visible au moyen d'un rayonnement X,

m) la formation du motif absorbant désiré sur la surface principale de la membrane, située à l'opposé des îlots en matière plastique transparente à la lumière visible.

6. Procédé de fabrication du masque selon les revendications 1 à 4, caractérisé en ce qu'on forme dans la membrane des fenêtres d'alignement en matière plastique transparente à la lumière visible ainsi que des sillons d'alignement en effectuant les étapes de procédé suivantes:

a) le dépôt d'une couche en matière plastique transparente à la lumière visible sur l'une des surfaces principales de la membrane,

b) le dépôt d'une couche de photorésist à effet négatif sur la couche transparente à la lumière visible,

c) le dépôt d'une couche de photorésist à effet positif sur l'autre surface principale de la membrane,

d) la stabilisation des deux couches de photorésist par recuit,

e) un processus de lithographie par faisceau électronique pour éliminer partiellement la couche de photorésist à effet positif à l'endroit des sillons d'alignement prévus et/ou pour éliminer entièrement la couche de photorésist à effet positif à l'endroit des fenêtres d'alignement prévues,

f) l'élimination partielle et/ou entière de la membrane à l'endroit des sillons et des fenêtres d'alignement prévus au moyen d'une étape d'attaque chimique,

g) la polymérisation de la couche de photorésist à effet négatif à l'endroit des fenêtres d'alignement,

h) l'élimination par exposition des parties non réticulées de la couche de photorésist à effet négatif ainsi que l'élimination par attaque chimique de la couche transparente à la lumière visible dans des parties situées en dehors des fenêtres d'alignement,

j) l'élimination de la couche de photorésist à effet positif de la membrane,

k) la stabilisation par rayons X de la couche transparente à la lumière visible,

l) la formation du motif absorbant désiré sur la surface principale de la membrane, située à l'opposé de la couche transparente à la lumière visible.

7. Procédé de fabrication du masque selon les revendications 1 à 4, caractérisé en ce qu'on forme dans la membrane des fenêtres d'alignement en matière plastique transparente à la lumière visible en effectuant les étapes de procédé suivantes:

a) le dépôt d'une couche en matière plastique transparente à la lumière visible sur l'une des surfaces principales de la membrane,

b) le dépôt d'une couche de photorésist à effet positif sur l'autre surface principale de la membrane,

c) la stabilisation de la couche de photorésist par recuit,

d) l'exposition de la couche de photorésist à effet positif a l'endroit des fenêtres d'alignement prévues,

e) l'élimination de la couche de photorésist à effet positif à l'endroit des fenêtres d'alignement prévues,

f) l'élimination par attaque chimique de la membrane dans les parties mises à découvert de la couche de photorésist à effet positif pour former les fenêtres d'alignement,

g) l'élimination de la couche de photorésist à effet positif de la membrane,

h) la stabilisation par rayons X de la couche transparente à la lumière visible,

j) la formation du motif absorbant désiré sur la surface principale de la membrane, située à l'opposé de la couche en matière plastique transparente à la lumière visible.

8. Procédé de fabrication du masque selon les revendications 1 à 4, caractérisé en ce qu'on forme dans la membrane des fenêtres d'alignement en matière plastique transparente à la lumière visible en effectuant les étapes de procédé suivantes:

a) le dépôt de la membrane sous la forme d'une couche mince sur l'une des surfaces principales d'une feuille transparente à la lumière visible,

b) le dépôt d'une couche de photorésist à effet négatif sur l'autre surface principale de la feuille transparente à la lumière visible,

c) le dépôt d'une couche de photorésist à effet positif sur la couche mince servant de membrane,

d) la stabilisation des deux couches de photorésist par recuit,

e) l'exposition de la couche de photorésist à effet positif à l'endroit des fenêtres d'alignement prévues,

f) l'élimination de la couche de photorésist à effet positif à l'endroit des fenêtres d'alignement prévues,

g) l'élimination par attaque chimique de la membrane dans les parties mises à découvert de la couche de photorésist à effet positif pour former les fenêtres d'alignement,

h) la polymérisation de la couche de photorésist à effet négatif à l'endroit des fenêtres d'alignement,

j) l'élimination par développement des parties non réticulées de la couche de photorésist à effet négatif ainsi que l'élimination par attaque chimique de la feuille transparente à la lumière visible dans les parties situées en dehors des fenêtres d'alignement.

k) l'élimination de la couche de photorésist à effet positif de la membrane,

l) la stabilisation de la feuille transparente à la lumière visible au moyen d'un rayonnement X,

m) la formation du motif absorbant désiré sur la surface principale de la membrane, située à l'opposé des îlots en matière plastique transparente à la lumière visible.

9. Procédé de fabrication du masque selon les revendications 1 à 4, caractérisé en ce qu'on forme dans la membrane des fenêtres d'alignement en matière plastique transparente à la lumière visible ainsi que des sillons d'alignement en effectuant les étapes de procédé suivantes:

a) le dépôt de la membrane sous la forme d'une couche mince sur l'une des surfaces principales d'une feuille transparente à la lumière visible,

b) le dépôt d'une couche de photorésist à effet négatif sur l'autre surface principale de la feuille transparente à la lumière visible,

c) le dépôt d'une couche de photorésist à effet positif sur la couche mince servant de membrane,

d) la stabilisation des deux couches de photorésist par recuit,

e) un processus de lithographie par faisceau électronique pour éliminer partiellement la couche de photorésist à effet positif à l'endroit des sillons d'alignement prévus et/ou pour l'élimination complète de la couche de photorésist à effet positif à l'endroit des fenêtres d'alignement prévues,

f) l'élimination partielle et/ou complète de la membrane à l'endroit des sillons et des fenêtres d'alignement prévus en effectuant une étape d'attaque chimique,

g) la polymérisation de la couche de photorésist à effet négatif à l'endroit des fenêtres d'alignement,

h) l'élimination par développement des parties non réticulées de la couche de photorésist à effet négatif ainsi que l'élimination par attaque chimique de la feuille transparente à la lumière visible dans les parties situées en dehors des fenêtres d'alignement,

j) l'élimination de la couche de photorésist à effet positif de la membrane,

k) la stabilisation de la feuille transparente à la lumière visible au moyen d'un rayonnement X,

l) la formation du motif absorbant désiré sur la surface principale de la membrane, située à l'opposé de la feuille transparente à la lumière visible.

10. Procédé selon au moins l'une des revendications 5 à 9, caractérisé en ce qu'on utilise du titane comme matériau de la membrane.

11. Procédé selon au moins l'une des revendications 5 à 9, caractérisé en ce qu'on utilise un polyimide comme matière plastique transparente à la lumière visible.

12. Procédé selon les revendications 5 à 7, 11, 13, caractérisé en ce que le polyimide utilisé est une résine synthétique qu'on dépose sous la forme d'une couche.

13. Procédé selon au moins l'une des revendications 8, 9 et 11, caractérisé en ce que le polyimide utilisé est un demi-produit en forme de feuille.

14. Procédé selon au moins l'une des revendications 5 à 9, caractérisé en ce qu'on réalise la membrane sur un substrat par dépôt de plusieurs couches individuelles superposées en sandwich et ayant des contraintes de traction ou de compression différentes et en ce qu'on l'enlève ensuite de ce substrat.

15. Application du masque selon les revendications 1 à 14 à la fabrication de dispositifs semiconducteurs.

16. Application du masque selon les revendications 1 à 14 à la fabrication de dispositifs à domaines cylindriques.

FIG.1

FIG.2